# EUROPEAN PATENT SPECIFICATION

(11) **EP 4 481 418 B1**
(45) Date of publication and mention of the grant of the patent: **16.09.2026**
(21) Application number: 23868322.1
(22) Date of filing: 22.06.2023
(51) Int. Cl.: H01M 10/42, H01M 10/48, H02J 7/80, H02J 13/12, G01R 31/382, H02J 13/13

(54) **BATTERY MANAGEMENT SYSTEM HAVING HIERARCHICAL STRUCTURE AND METHOD FOR OPERATING SAME**
BATTERIEVERWALTUNGSSYSTEM MIT HIERARCHISCHER STRUKTUR UND VERFAHREN ZUM BETRIEB DAVON
CALCULATEUR DE GESTION DE BATTERIE AYANT UNE STRUCTURE HIÉRARCHIQUE ET SON PROCÉDÉ DE FONCTIONNEMENT

(30) Priority: 20.09.2022 KR 20220118506; 09.06.2023 KR 20230074116
(43) Date of publication of application: 25.12.2024
(73) Proprietor: LG Energy Solution, Ltd., Seoul 07335 (KR)
(72) Inventor: LEE, Seunghyun, Daejeon 34122 (KR); KIM, Tae Youn, Daejeon 34122 (KR); SEO, Bo Hyun, Daejeon 34122 (KR); CHOI, Jang Hyeok, Daejeon 34122 (KR)
(74) Representative: Plasseraud IP
(86) International application number: PCT/KR2023/008699
(87) International publication number: WO 2024/063262

(56) References cited:
- EP-A1- 3 557 687
- JP-B2- 5 088 557
- JP-B2- 5 930 431
- KR-A- 20100 097 504
- KR-A- 20130 081 683
- KR-A- 20150 018 993
- KR-B1- 101 925 773
- US-A1- 2012 275 527

## Description

### [Technical Field]

This application claims priority to and the benefit of Korean Patent Application No.10-2022-0118506 filed in the Korean Intellectual Property Office on September 20, 2022 and Korean Patent Application No.10-2023-0074116 filed in the Korean Intellectual Property Office on June 9, 2023.

The present invention relates to a battery management system having a hierarchical structure and an operating method thereof, and more particularly, to a battery management system including a master BMS and a slave BMS and an operating method thereof.

### [Background Art]

A secondary battery is a battery that can be recharged and reused even after being discharged. The secondary battery can be used as an energy source for small devices such as mobile phones, tablet PCs and vacuum cleaners, and also used as an energy source for medium and large devices such as ESS (Energy Storage System) for automobiles and smart grids.

The secondary battery is applied to a system in a form of an assembly such as a battery module in which a plurality of battery cells are connected in series and parallel or a battery pack in which battery modules are connected in series and parallel according to system requirements. In a case of medium or large-sized devices such as electric vehicles, a high-capacity battery system in which a plurality of battery packs are connected in parallel may be applied in order to satisfy a required capacity of the device.

A battery management system that monitors and controls a state and operations of a battery pack may have a hierarchical structure in order to efficiently monitor and control all battery cells included in the battery pack. More specifically, the battery management system may include a plurality of slave BMSs that collect state information of battery cells or battery modules and a master BMS that collects state information of a battery pack, and receives cell/module state information from the slave BMSs for integrated monitoring and control.

In order for the hierarchical structured battery management system to perform state diagnosis more accurately, it is necessary to diagnose whether or not the battery is abnormal using several pieces of state information measured at the same time, but a device that collect pack state information and a device that collect information about cell or module state are configured separately and communication lines of respective devices are separated, so that a time error among several pieces of state information may occur. Due to this time error among the several pieces of state information, the reliability for diagnosis result of the battery management system may be limited.

Further prior art is described in EP 3 557 687 A1, JP 5 930431 B2, and JP 5 088557 B2.

### [Detailed Description of the Invention]

### [Technical Problem]

To obviate one or more problems of the related art, it is an object of the present disclosure to provide a battery system having a hierarchical structure.

To obviate one or more problems of the related art, it is a further object of the present disclosure to also provide a method for operating a battery system having a hierarchical structure.

### [Technical Solution]

In order to achieve the objective of the present disclosure, a battery management system (BMS) includes a plurality of slave BMSs and a master BMS configured to interwork with the plurality of slave BMSs and to monitor a battery group including a plurality of batteries, wherein the master BMS is configured to collect state information on one or more batteries from the plurality of slave BMSs and to collect state information on the battery group from a group state information collecting device provided in the master BMS and the plurality of slave BMSs and the group state information collecting device are sequentially connected through a serial communication network, wherein the master BMS includes: a controller; and a communication interface device, wherein the battery management system (BMS) has a hierarchical structure and the controller and the communication interface device are sequentially connected to the plurality of slave BMSs and the group state information collecting device through the serial communication network, and wherein the controller is configured to receive the status information on the one or more batteries and the status information on the battery group through the communication interface device, wherein the status information on the one or more batteries and the status information on the battery group are generated at the same time.

The controller may be configured to diagnose whether the battery or the battery group is abnormal based on the received state information on the one or more batteries and the state information on the battery group.

The communication interface device may be directly connected to the slave BMS located at an end of the plurality of slave BMSs through the serial communication network.

Upon the battery management system being switched to OFF state, the group state information collecting device may be configured to be switched to an inactive state and the plurality of slave BMSs are configured to wake-up at a predefined time.

The plurality of slave BMSs may wake-up every predefined unit time to collect state information on the one or more batteries, in an OFF state of the battery management system and diagnose whether a battery to be managed is abnormal based on the collected state information.

Upon an abnormality occurring in one or more batteries, the slave BMS may transmit an abnormality signal to the communication interface device through the serial communication network and the communication interface device may be configured to transmit a wake-up signal to the controller to switch the battery management system to an ON state.

The state information on the battery group may include one or more information of a voltage value, a current value, and an insulation resistance value in units of battery groups, and the state information on the one or more batteries may include one or more information of voltage values, current values, and temperature values in units of battery cells or battery subgroups.

The group state information collecting device may be configured as an integrated module including a group voltage information collecting module, a group current information collecting module and an insulation resistance information collecting module.

According to another embodiment of the present disclosure, an operating method of a battery management system (BMS), which includes a plurality of slave BMSs and a master BMS sequentially connected with the plurality of slave BMSs through a serial communication network, includes: collecting, by the plurality of slave BMSs, state information on one or more batteries; collecting, by a group state information collecting device provided in the master BMS, state information on the battery group; receiving, by a controller of the master BMS, status information on the one or more batteries and status information on the battery group through a communication interface device of the master BMS; and monitoring abnormality in the one or more batteries or in the battery group based on the collected state information, wherein the controller and the communication interface device are sequentially connected to the plurality of slave BMSs and the group state information collecting device through the serial communication network, and wherein the receiving status information includes receiving, through the communication interface device, status information on the one or more batteries and status information on the battery group which are generated at the same time.

The monitoring abnormality may include diagnosing whether the battery or the battery group is abnormal based on the received state information on the one or more batteries and the state information on the battery group.

The communication interface device may directly be connected to the slave BMS located at an end of the plurality of slave BMSs through the serial communication network.

### [Advantageous Effects]

According to the embodiment of the present invention as described above, the battery management system can diagnose a battery system based on time-synchronized state information, thereby improving reliability of monitoring and diagnosis results by the battery management system.

In addition, monitoring and diagnosis can be stably performed even in an OFF state of the battery management system according to embodiments of the present invention.

### [Brief Description of the Drawings]

FIG. 1 is a block diagram of a general battery management system.
FIG. 2 is a block diagram of a battery management system according to embodiments of the present invention.
FIG. 3 is a block diagram illustrating an implementation example of a battery management system according to the present invention.
FIG. 4 is an operation flowchart of a method for operating a battery management system according to embodiments of the present invention.
FIG. 5 is a block diagram of a battery management system to which a serial communication line according to embodiments of the present invention is applied.
FIG. 6 is an operation flowchart of a method of operating the battery management system shown in FIG. 5.

- 100:: Master BMS
- 110:: controller
- 120:: communication interface device
- 130:: group state information collecting device
- 200:: slave BMS
- 300:: serial communication network
- 400:: serial communication line

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

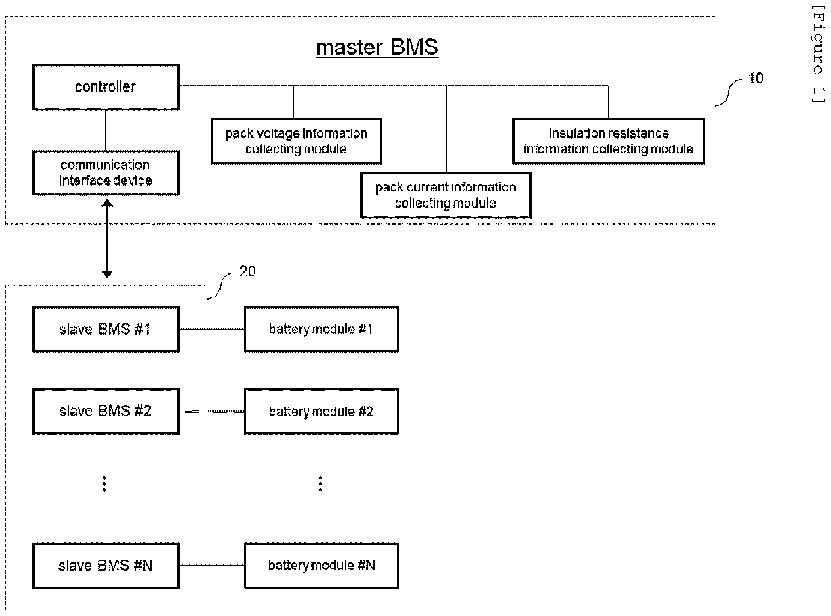

FIG. 1 is a block diagram of a general battery management system.

Referring to FIG. 1, the battery management system may include a master BMS 10 and a plurality of slave BMSs 20.

The master BMS 10 is an upper layer BMS that monitors and controls a battery system including a plurality of battery modules #1 to #N. The master BMS 10 may include a plurality of pack state information collecting devices that collect state information of the battery pack. As shown in FIG. 1, the state information collecting device may include a pack voltage information collecting module, a pack current information collecting module, and an insulation resistance information collecting module.

The plurality of slave BMSs 20 each of which is a lower layer BMS are provided in correspondence with the plurality of battery modules #1 to #N, collect state information on the corresponding battery modules, and transmit the collected state information to the master BMS 10. Here, each of the slave BMSs may include a device for collecting module state information including one or more information of a voltage value, a current value, and a temperature value of each cell included in the battery module, and a voltage value, a current value, and a temperature value of each battery module, or each of the slave BMSs may be connected to the device for collecting module state information.

The master BMS 10 may include a communication interface device, and may be configured to transmit/receive data with a plurality of slave BMSs 20 through the communication interface device. Here, the master BMS 10 may receive module state information (cell state information and module state information) from each of the plurality of slave BMSs 20 through the communication interface device.

Referring to FIG. 1, the master BMS 10 may be configured to include a controller that receives pack state information from pack state information collecting devices (pack voltage information collecting module, pack current information collecting module, and insulation resistance information collecting module) provided therein, and receives module state information from each of the plurality of slave BMSs 20 through the communication interface. Here, the controller of the master BMS 10 may monitor the collected pack state information and module state information and diagnose whether the battery system is abnormal.

Referring to FIG. 1, in the case of a general battery management system, pack state information collecting devices and module state information collection devices are separately configured, and communication is performed while a communication line for collecting pack state information and a communication line for collecting module state information are separated. Accordingly, several pieces of state information collected by the controller are data with a time error that is not measured at the same time. Due to this time error among several pieces of state information, the reliability for diagnosis result of the battery management system may be limited.

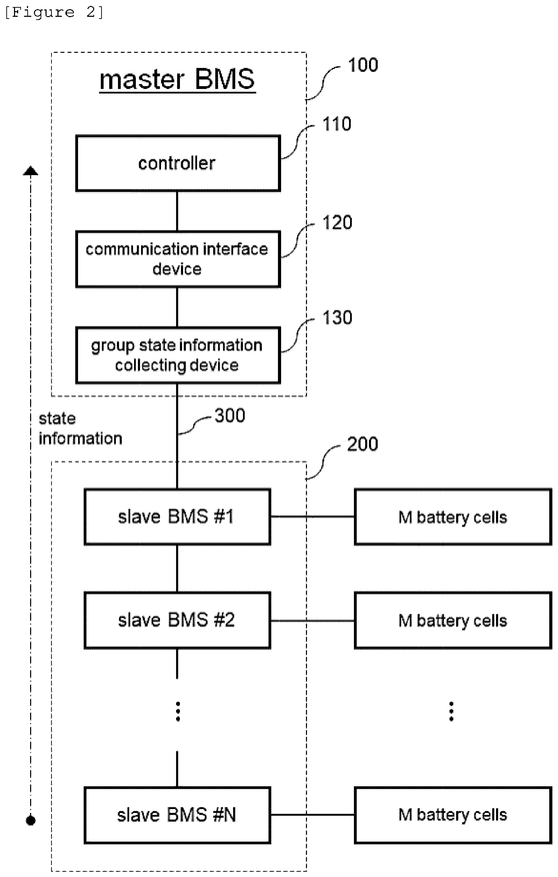

The present invention is presented to solve these technical problems. Hereinafter, the structure and operation method of a battery management system according to various embodiments of the present disclosure will be described in detail with reference to FIGS. 2 to 6.

FIG. 2 is a block diagram of a battery management system according to embodiments of the present invention.

Referring to FIG. 2, a battery management system according to embodiments of the present invention includes a master BMS 100 and a plurality of slave BMS 200.

The master BMS 100 is an upper layer BMS that monitors and controls a battery system including a plurality of batteries.

The master BMS 100 may include a controller 110, a communication interface device 120 and a group state information collecting device 130.

The controller 110 may monitor states of one or more of the batteries and battery groups included in the battery system and diagnose abnormalities. Here, the battery group may mean a battery module, a battery pack, a battery rack, or a battery bank.

The controller 110 may diagnose whether or not there is an abnormality in one or more of the batteries and battery groups based on the state information on the battery group transmitted from the group state information collecting device and the state information on one or more batteries transmitted from the plurality of slave BMSs 200.

The communication interface device 120 may include a communication module that receives state information from the group state information collecting device 130 and the plurality of slave BMSs 200 and transmits the state information to the controller 110.

The group state information collecting device 130 may collect state information in units of battery groups and transmit the collected group state information to the communication interface device 120. Here, the group state information collecting device 130 may be configured as an integrated module including a group voltage information collecting module, a group current information collecting module, and an insulation resistance information collecting module. Other words, unlike a general battery management system as shown in FIG. 1, the group state information collecting device 130 according to embodiments of the present invention may be configured as one integrated module including a group voltage information collecting module, a group current information collecting module, and an insulation resistance information collecting module, and configured to simultaneously transmit the collected group state information (e.g., voltage value, current value, and insulation resistance value of each battery pack unit) to the communication interface device 120.

The plurality of slave BMSs 200 are lower layer BMSs that manage one or more batteries, respectively. Here, each of the slave BMSs may collect state information on a corresponding battery to be managed and transmit collected battery state information to the master BMS 100.

Each of the slave BMSs may be configured to include a state information collecting device for collecting state information of a battery to be managed, or to be connected to the state information collecting device. Here, the battery state information collected by a slave BMS may include state information of one or more of a voltage value, a current value, and a temperature value of a battery cell or battery subgroup unit (e.g., module unit).

The plurality of slave BMSs 200 may be sequentially connected to the group state information collecting device 130 of the master BMS 100 through a serial communication network. In addition, the controller 110 and the communication interface device 120 of the master BMS 100 may be sequentially connected to the group state information collecting device 130 and the plurality of slave BMSs 200 through a serial communication network. Referring to FIG. 2, a controller 110, a communication interface device 120, a group state information collecting device 130, and a plurality of slave BMSs 200 may be sequentially connected through a serial communication network 300.

Each of the components 110, 120, and 130 of the master BMS 100 and each of the plurality of slave BMSs 200 may include a communication module for forming the serial connection network 300 shown in FIG. 2. For example, the serial connection network 300 according to embodiments of the present invention may correspond to a daisy-chain communication network, and each of the components 110, 120, 130, and 200 in the master BMS 100 may include a data transceiving module to form a daisy-chain communication network.

From the slave BMS (#N) at the end to the slave BMS (#1) at the top, each collected battery state information may be transmitted to the controller 110 through the serial communication network 300. Furthermore, the group state information collecting device 130 may transmit the collected group state information to the controller 110 through the serial communication network 300. Here, the group state information collecting device 130, as described above, may be configured as an integrated module including a group voltage information collecting module, a group current information collecting module, and an insulation resistance information collecting module, and thus, group state information including voltage values, current values, and insulation resistance values in group units may be transmitted to the controller 110.

In an embodiment, the battery state information and the group state information may correspond to state information generated at the same time. According to this embodiment, the controller 110 may receive pieces of time-synchronized state information (e.g., battery cell state information, module state information, and pack state information), monitor the battery system using the received state information, and diagnose abnormalities in the battery system. Accordingly, reliability of monitoring and diagnosis results by the battery management system may be improved.

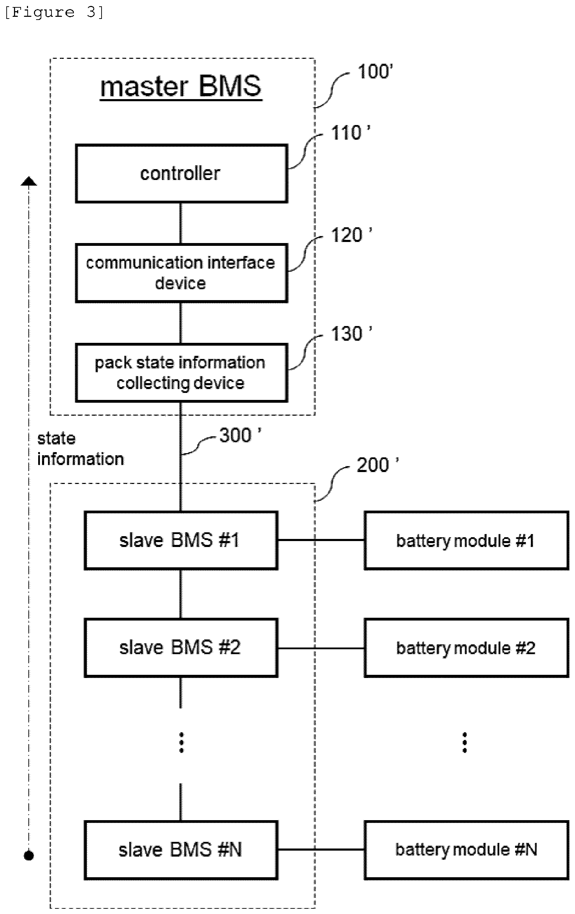

FIG. 3 is a block diagram illustrating an implementation example of a battery management system according to the present invention. Specifically, FIG. 3 is an implementation example of a battery management system in which a master BMS corresponds to a pack BMS and a slave BMS corresponds to a module BMS. Meanwhile, the battery management system shown in FIG. 3 is an example for clear description of the present invention, and the scope of the present invention is not limited thereto.

Referring to FIG. 3, a battery management system according to embodiments of the present invention may include a master BMS 100' and a plurality of slave BMSs 200'.

The master BMS 100' may correspond to a pack BMS that monitors and controls a battery pack including a plurality of battery modules.

The master BMS 100' may include a controller 110', a communication interface device 120', and a pack state information collecting device 130'.

The controller 110' may monitor the state of the battery pack and diagnose abnormalities in the battery pack. Here, the controller 110' may diagnose whether one or more of the battery cell, the battery module, and the battery pack are abnormal based on one or more of the pack state information transmitted from the pack state information collecting device and the module state information transmitted from the plurality of slave BMSs 200'.

The communication interface device 120' may be configured to include a communication module that receives state information from the plurality of slave BMSs 200' and a pack state information collecting device 130', and transmits the received state information to the controller 110' .

The pack state information collecting device 130' may collect pack state information in units of battery packs and transmit the collected pack state information to the communication interface device 120'. Here, the pack state information collecting device 130' may be configured as an integrated module including a pack voltage information collecting module, a pack current information collecting module, and an insulation resistance information collecting module.

The plurality of slave BMSs 200' may correspond to module BMSs provided in correspondence with the plurality of battery modules #1 to #N, respectively. Here, the slave BMS may collect state information on the corresponding battery module and transmit the collected module state information to the master BMS 100'.

Each of the slave BMSs may include a module state information collecting device for collecting module status information, or may be configured to be connected to the module state information collection device. Here, the module state information may include one or more state information of a voltage value, a current value, and a temperature value of each cell included in the battery module, and a voltage value, a current value, and a temperature value of each battery module.

The plurality of slave BMSs 200' may be sequentially connected to the pack state information collecting device 130' of the master BMS 100' through a serial communication network. In addition, the controller 110' and the communication interface device 120' of the master BMS 100' may be sequentially connected to the pack state information collecting device 130' and the plurality of slave BMSs 200' through a serial communication network.

Each of the components 110', 120', and 130' of the master BMS 100' and each of the plurality of slave BMSs 200' may include a communication module to form the serial connection network 300' shown in FIG. 3.

From the slave BMS (#N) at the end to the slave BMS (#1) at the top, each collected module state information may be transmitted to the controller 110' through the serial communication network 300'. In addition, the pack state information collecting device 130' may transmit the collected pack state information to the controller 110' through the serial communication network 300'. Here, the module state information and the pack state information may correspond to state information generated at the same time.

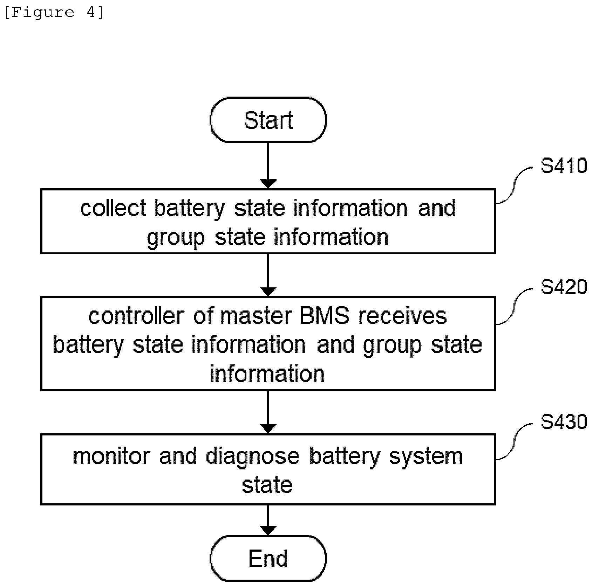

FIG. 4 is an operation flowchart of a method for operating a battery management system according to embodiments of the present invention.

The plurality of slave BMSs may collect state information on one or more batteries and the group state information collecting device of the master BMS may collect state information on battery groups (S410). Here, the state information on the battery group may include information on one or more of a voltage value, a current value, and an insulation resistance value in units of battery group (e.g., in units of pack). In addition, the state information on one or more batteries may include one or more of a voltage value, a current value, and a temperature value in units of battery cells or battery subgroups (e.g., in units of module). Here, the collected battery state information and group state information may correspond to time-synchronized state information generated at the same time.

Thereafter, the controller of the master BMS may receive battery state information and group state information (S420). More specifically, the plurality of slave BMSs and the group state information collecting device may transmit battery state information and group state information to the communication interface device through a serial communication network, and the communication interface device may transfer the delivered battery state information and group status information to the controller.

The controller may monitor and diagnose a battery or a battery group based on the received battery state information and group state information (S430).

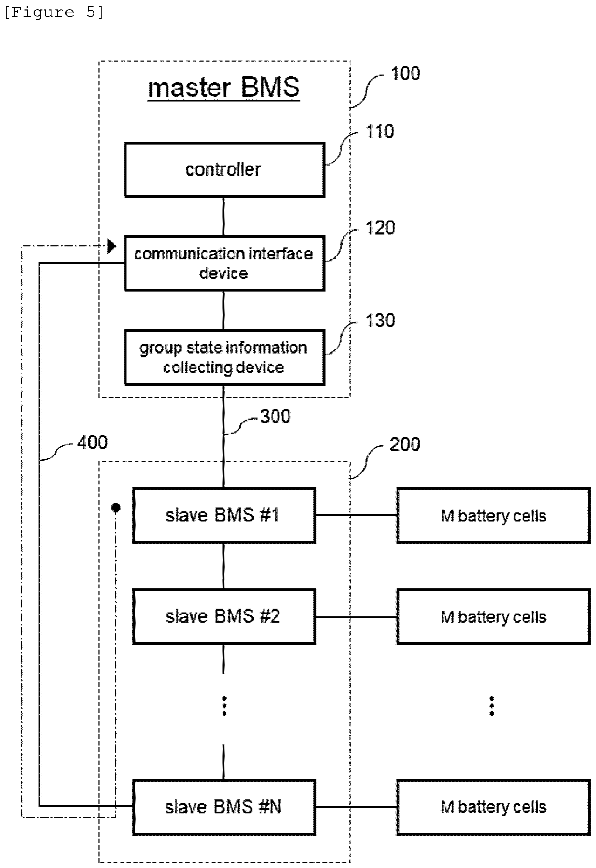

FIG. 5 is a block diagram of a battery management system to which a serial communication line according to embodiments of the present invention is applied.

The battery management system in FIG. 5 shows a structure further including a serial communication line 400 in the battery management system shown in FIG. 2, the serial communication line 400 directly connecting the slave BMS located at the end and the communication interface device 120.

Referring to FIG. 5, the slave BMS (#N) positioned at the end, among the plurality of slave BMSs 200, may be configured to be directly connected to the communication interface device 120 through the serial communication line 400. According to this embodiment, the battery management system may monitor the battery system even when it is in an OFF state, and may be switched to an ON state when abnormality occurs in the battery system.

When the battery management system is switched to an OFF state, the group state information collecting device 130 may be configured to be switched to an inactive state, and the plurality of slave BMSs 200 to wake-up at a predefined time.

More specifically, when the battery management system becomes turned off, the group state information collecting device 130 may be configured not to collect group state information, and the plurality of slave BMSs 200 may be configured to receive power through a regular power supply, wake-up every pre-defined time, and collect battery state information (e.g., voltage value, current value, temperature value of a cell, voltage value, current value, temperature value, of a module, etc.).

The plurality of slave BMSs 200 may diagnose whether a battery under management is abnormal based on the collected battery state information. Here, when an abnormality occurs in one or more batteries (e.g., when a voltage of a specific cell or module exceeds a predefined threshold), one or more corresponding slave BMSs may generate an abnormality signal. Here, the corresponding slave BMS may transfer the generated abnormality signal to the communication interface device 120 through the serial communication line 400. In other words, in an OFF state of the battery management system, the plurality of slave BMSs 200 may monitor respective batteries being managed, and, when an abnormality occurs, the slave BMS managing the abnormal battery may transmit an abnormality signal to the communication interface device 120 through the serial communication line 400 (a direction opposite to the communication direction in ON state shown in FIG. 2).

The communication interface device 120 may be configured to operate by receiving power through a constant power supply in an OFF state of the battery management system.

The communication interface device 120 may be configured to switch the battery management system into an ON state when an abnormality occurs in one or more batteries. For example, the plurality of slave BMSs 200 diagnose whether a battery under management is abnormal, and may transmit an abnormality signal indicating an abnormality to the communication interface device 120 through the serial communication line 400 when an abnormality occurs. Here, upon receiving the abnormality signal, the communication interface device 120 may generate a wake-up signal using a wake-up circuit and transmit the wake-up signal to the controller 110. The controller 110 may receive the wake-up signal and turn the battery management system to ON state.

In other words, in OFF state of the battery management system, the battery system may be monitored through the communication interface device 120, the slave BMS 200, and a separate serial communication line 400, whereas, when an abnormality occurs, the battery management system is switched to ON state and the controller 110 may diagnose abnormality in the entire battery system.

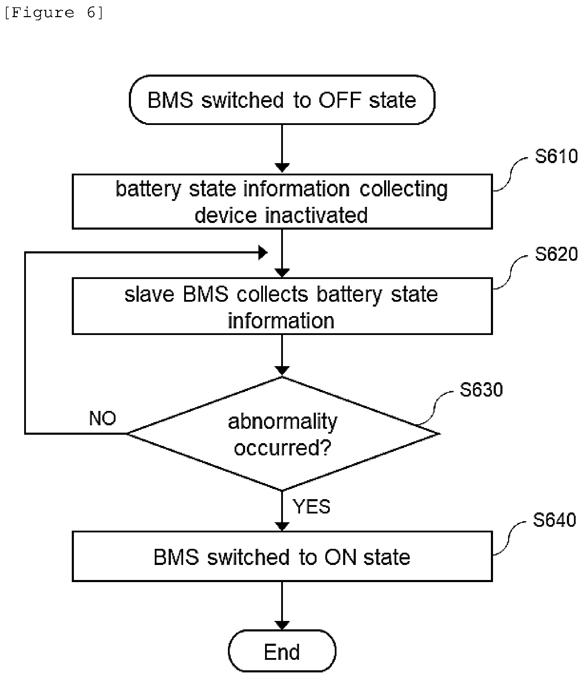

FIG. 6 is an operation flowchart of a method of operating the battery management system shown in FIG. 5.

Referring to FIGS. 5 and 6, when the battery management system is turned OFF, the group state information collecting device may be turned into an inactive state (S610).

Thereafter, the plurality of slave BMSs may be supplied with power through a constant power supply, wake-up every predefined time, and collect battery state information (e.g., a voltage value, a current value, and a temperature value of a cell, and a voltage value, a current value, and a temperature value of a module, etc.) (S620).

Each of the slave BMSs may diagnose whether or not the battery under management is abnormal based on the battery state information (S630).

When an abnormality occurs in one or more batteries (YES in S630), the communication interface device may switch the battery management system to an ON state (S640). For example, when an abnormality occurs in a specific battery module, the communication interface device may receive an abnormality signal from a slave BMS corresponding to the module generating abnormality. Thereafter, the communication interface device may generate a wake-up signal through a wake-up circuit and transmit the wake-up signal to the controller, and the controller may turn the battery management system into an ON state.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

## Claims

1. A battery management system (BMS) comprising:
a plurality of slave BMSs (200); and
a master BMS (100) configured to interwork with the plurality of slave BMSs (200) and to monitor a battery group including a plurality of batteries,
wherein the master BMS (100) is configured to collect state information on one or more batteries from the plurality of slave BMSs (200) and to collect state information on the battery group from a group state information collecting device provided in the master BMS (100), and
wherein the plurality of slave BMSs (200) and the group state information collecting device (130) are sequentially connected through a serial communication network (300),
wherein the master BMS (100) includes:
a controller (110); and
a communication interface device (120),
**characterized in that** the battery management system (BMS) has a hierarchical structure, and the controller (110) and the communication interface device (120) are sequentially connected to the plurality of slave BMSs (200) and the group state information collecting device (130) through the serial communication network (300), and
wherein the controller (110) is configured to receive the status information on the one or more batteries and the status information on the battery group through the communication interface device (120), wherein the status information on the one or more batteries and the status information on the battery group are generated at the same time.

2. The battery management system of claim 1, wherein the controller (110) is configured to diagnose whether the battery or the battery group is abnormal based on the received state information on the one or more batteries and the state information on the battery group.

3. The battery management system of claim 1, wherein the communication interface device (120) is directly connected to a slave BMS (200) located at the end of the plurality of slave BMSs (200) through the serial communication network (300).

4. The battery management system of claim 3, wherein, upon the battery management system being switched to OFF state, the group state information collecting device (130) is configured to be switched to an inactive state and the plurality of slave BMSs (200) are configured to wake-up at a predefined time.

5. The battery management system of claim 4, wherein the plurality of slave BMSs (200) wakes-up every predefined unit time to collect state information on the one or more batteries, in an OFF state of the battery management system and diagnose whether a battery to be managed is abnormal based on the collected state information.

6. The battery management system of claim 5, wherein,
upon an abnormality occurring in one or more batteries,
the slave BMS (200) transmits an abnormality signal to the communication interface device (120) through the serial communication network (300), and
the communication interface device is configured to transmit a wake-up signal to the controller (110) to switch the battery management system to an ON state.

7. The battery management system of claim 1, wherein the state information on the battery group includes one or more information of a voltage value, a current value, and an insulation resistance value in units of battery groups, and
wherein the state information on the one or more batteries includes one or more information of voltage values, current values, and temperature values in units of battery cells or battery subgroups.

8. The battery management system of claim 1, wherein the group state information collecting device (130) is configured as an integrated module including a group voltage information collecting module, a group current information collecting module and an insulation resistance information collecting module.

9. An operating method of a battery management system (BMS) including a plurality of slave BMSs (200) and a master BMS (100) sequentially connected with the plurality of slave BMSs (200) through a serial communication network (300), the method comprising:
collecting (S410), by the plurality of slave BMSs (200), state information on one or more batteries;
collecting (S410), by a group state information collecting device (130) provided in the master BMS (100), state information on the battery group including a plurality of batteries;
receiving (S420), by a controller (110) of the master BMS (100), status information on the one or more batteries and status information on the battery group through a communication interface device (120) of the master BMS (100); and
monitoring (S430) abnormality in the one or more batteries or in the battery group based on the collected state information,
**characterized in that** the controller (110) and the communication interface device (120) are sequentially connected to the plurality of slave BMSs (200) and the group state information collecting device (130) through the serial communication network, and
wherein the receiving status information includes receiving the status information on the one or more batteries and the status information on the battery group, wherein the status information on the one or more batteries and the status information on the battery group are generated at the same time.

10. The method of claim 9, wherein the monitoring (S430) abnormality includes diagnosing whether the battery or the battery group is abnormal based on the received state information on the one or more batteries and the state information on the battery group.

11. The method of claim 9, wherein the communication interface device (120) is directly connected to a slave BMS (200) located at the end of the plurality of slave BMSs (200) through the serial communication network (300).

## Patentansprüche

1. Batteriemanagementsystem (BMS), umfassend:
eine Vielzahl von Slave-BMS (200); und
ein Master-BMS (100), das so konfiguriert ist, dass es mit der Vielzahl von Slave-BMS (200) zusammenwirkt und eine Batteriegruppe überwacht, die eine Vielzahl von Batterien enthält,
wobei das Master-BMS (100) so konfiguriert ist, dass es Zustandsinformationen über eine oder über mehrere Batterien aus der Vielzahl von Slave-BMS (200) sammelt und Zustandsinformationen über die Batteriegruppe von einer Gruppenzustandsinformation-Sammelvorrichtung sammelt, die in dem Master-BMS (100) bereitgestellt ist, und
wobei die Vielzahl von Slave-BMS (200) und die Gruppenzustandsinformation-Sammelvorrichtung (130) sequenziell über ein serielles Kommunikationsnetzwerk (300) verbunden sind,
wobei das Master-BMS (100) Folgendes umfasst:
eine Steuerung (110); und
eine Kommunikationsschnittstellenvorrichtung (120),
**dadurch gekennzeichnet, dass** das Batteriemanagementsystem (BMS) eine hierarchische Struktur aufweist und die Steuerung (110) und die Kommunikationsschnittstellenvorrichtung (120) in Reihe mit der Vielzahl von Slave-BMS (200) und der Gruppenzustandsinformation-Sammelvorrichtung (130) über das Netzwerk für serielle Kommunikation (300) verbunden sind, und
wobei die Steuerung (110) so konfiguriert ist, dass sie die Zustandsinformationen über die eine oder über mehrere Batterien und die Zustandsinformationen über die Batteriegruppe über die Kommunikationsschnittstellenvorrichtung (120) empfängt, wobei die Zustandsinformationen über die eine oder über mehrere Batterien und die Zustandsinformationen über die Batteriegruppe zur gleichen Zeit erzeugt werden.

2. Das Batteriemanagementsystem nach Anspruch 1, wobei die Steuerung (110) so konfiguriert ist, dass sie auf der Grundlage der empfangenen Zustandsinformationen über die eine oder über mehrere Batterien und der Zustandsinformationen über die Batteriegruppe diagnostiziert, ob die Batterie oder die Batteriegruppe eine Anomalie aufweist.

3. Das Batteriemanagementsystem nach Anspruch 1, wobei die Kommunikationsschnittstellenvorrichtung (120) über das Netzwerk für serielle Kommunikation (300) direkt mit einem Slave-BMS (200) verbunden ist, das sich am Ende der Vielzahl von Slave-BMS (200) befindet.

4. Das Batteriemanagementsystem nach Anspruch 3, wobei, wenn das Batteriemanagementsystem in einen AUS-Zustand geschaltet wird, die Gruppenzustandsinformation-Sammelvorrichtung (130) so konfiguriert ist, dass sie in einen inaktiven Zustand geschaltet wird, und die Vielzahl von Slave-BMS (200) so konfiguriert sind, dass sie zu einem vordefinierten Zeitpunkt aktiv werden.

5. Das Batteriemanagementsystem nach Anspruch 4, wobei die Vielzahl von Slave-BMS (200) in einem AUS-Zustand des Batteriemanagementsystems zu jeder vordefinierten Zeiteinheit aktiv werden, um Zustandsinformationen über die eine oder über mehrere Batterien zu sammeln und auf der Grundlage der gesammelten Zustandsinformationen zu diagnostizieren, ob eine zu verwaltende Batterie eine Anomalie aufweist.

6. Das Batteriemanagementsystem nach Anspruch 5, wobei
beim Auftreten einer Anomalie in einer oder mehreren Batterien
das Slave-BMS (200) ein Anomaliesignal über das Netzwerk für serielle Kommunikation (300) an die Kommunikationsschnittstellenvorrichtung (120) überträgt,
und die Kommunikationsschnittstellenvorrichtung so konfiguriert ist, dass sie ein Wecksignal an die Steuerung (110) überträgt, um das Batteriemanagementsystem in einen EIN-Zustand zu schalten.

7. Das Batteriemanagementsystem nach Anspruch 1, wobei die Zustandsinformationen über die Batteriegruppe eine Information oder mehrere Informationen über einen Spannungswert, einen Stromwert und einen Isolationswiderstandswert in Einheiten von Batteriegruppen umfassen, und
wobei die Zustandsinformationen über die eine oder über mehrere Batterien eine oder mehrere Informationen über Spannungswerte, Stromwerte und Temperaturwerte in Einheiten von Batteriezellen oder Batterieuntergruppen umfassen.

8. Das Batteriemanagementsystem nach Anspruch 1, wobei die Gruppenzustandsinformation-Sammelvorrichtung (130) als integriertes Modul konfiguriert ist, das ein Gruppenspannungsinformation-Sammelmodul, ein Gruppenstrominformation-Sammelmodul und ein Isolationswiderstandsinformation-Sammelmodul umfasst.

9. Betriebsverfahren für ein Batteriemanagementsystem (BMS), das eine Vielzahl von Slave-BMS (200) und ein Master-BMS (100) umfasst, das in Reihe mit der Vielzahl von Slave-BMS (200) über ein Netzwerk für serielle Kommunikation (300) verbunden ist, wobei das Verfahren umfasst:
Sammeln (S410) von Zustandsinformationen über eine oder über mehrere Batterien durch die Vielzahl von Slave-BMS (200);
Sammeln (S410) von Zustandsinformationen über die Batteriegruppe, die eine Vielzahl von Batterien enthält, durch eine Gruppenzustandsinformation-Sammelvorrichtung (130), die im Master-BMS (100) bereitgestellt ist;
Empfangen (S420) von Zustandsinformationen über die eine oder über mehrere Batterien und Zustandsinformationen über die Batteriegruppe durch eine Steuerung (110) des Master-BMS (100) über eine Kommunikationsschnittstellenvorrichtung (120) des Master-BMS (100); und
Überwachen (S430) einer Anomalie in der einen oder in mehreren Batterien oder in der Batteriegruppe auf der Grundlage der gesammelten Zustandsinformationen,
**dadurch gekennzeichnet, dass** die Steuerung (110) und die Kommunikationsschnittstellenvorrichtung (120) in Reihe mit der Vielzahl von Slave-BMS (200) und der Gruppenzustandsinformation-Sammelvorrichtung (130) über das Netzwerk für serielle Kommunikation verbunden sind, und
wobei das Empfangen der Zustandsinformationen das Empfangen der Zustandsinformationen über die eine oder über mehrere Batterien und der Zustandsinformationen über die Batteriegruppe umfasst, wobei die Zustandsinformationen über die eine oder über mehrere Batterien und die Zustandsinformationen über die Batteriegruppe zur gleichen Zeit erzeugt werden.

10. Das Verfahren nach Anspruch 9, wobei das Überwachen (S430) einer Anomalie das Diagnostizieren umfasst, ob die Batterie oder die Batteriegruppe eine Anomalie aufweist, basierend auf den empfangenen Zustandsinformationen über die eine oder über mehrere Batterien und den Zustandsinformationen über die Batteriegruppe.

11. Das Verfahren nach Anspruch 9, wobei die Kommunikationsschnittstellenvorrichtung (120) über das Netzwerk für serielle Kommunikation (300) direkt mit einem Slave-BMS (200) verbunden ist, das sich am Ende der Vielzahl von Slave-BMS (200) befindet.

## Revendications

1. Système de gestion de batterie (BMS) comprenant :
une pluralité de BMS esclaves (200) ; et
un BMS maître (100) configuré pour interagir avec la pluralité de BMS esclaves (200) et pour surveiller un groupe de batteries incluant une pluralité de batteries,
dans lequel le BMS maître (100) est configuré pour collecter des informations d'état sur une ou plusieurs batteries à partir de la pluralité de BMS esclaves (200) et pour collecter des informations d'état sur le groupe de batteries à partir d'un dispositif de collecte d'informations d'état de groupe prévu dans le BMS maître (100), et
dans lequel la pluralité de BMS esclaves (200) et le dispositif de collecte d'informations d'état de groupe (130) sont connectés séquentiellement par l'intermédiaire d'un réseau de communication en série (300),
dans lequel le BMS maître (100) inclut :
un contrôleur (110) ; et
un dispositif d'interface de communication (120),
**caractérisé en ce que** le système de gestion de batterie (BMS) a une structure hiérarchique, et le contrôleur (110) et le dispositif d'interface de communication (120) sont connectés séquentiellement à la pluralité de BMS esclaves (200) et au dispositif de collecte d'informations d'état de groupe (130) par l'intermédiaire du réseau de communication en série (300), et
dans lequel le contrôleur (110) est configuré pour recevoir les informations d'état sur la ou les plusieurs batteries et les informations d'état sur le groupe de batteries par l'intermédiaire du dispositif d'interface de communication (120), dans lequel les informations d'état sur la ou les plusieurs batteries et les informations d'état sur le groupe de batteries sont générées en même temps.

2. Le système de gestion de batterie selon la revendication 1, dans lequel le contrôleur (110) est configuré pour diagnostiquer si la batterie ou le groupe de batteries est anormal sur la base des informations d'état reçues sur la ou les plusieurs batteries et des informations d'état sur le groupe de batteries.

3. Le système de gestion de batterie selon la revendication 1, dans lequel le dispositif d'interface de communication (120) est directement connecté à un BMS esclave (200) situé à l'extrémité de la pluralité de BMS esclaves (200) par l'intermédiaire du réseau de communication en série (300).

4. Le système de gestion de batterie selon la revendication 3, dans lequel, lorsque le système de gestion de batterie est commuté à un état OFF, le dispositif de collecte d'informations d'état de groupe (130) est configuré pour être commuté à un état inactif et la pluralité de BMS esclaves (200) sont configurés pour se réveiller à un temps prédéfini.

5. Le système de gestion de batterie selon la revendication 4, dans lequel la pluralité de BMS esclaves (200) se réveillent à chaque unité de temps prédéfinie pour collecter des informations d'état sur la ou les plusieurs batteries, dans un état OFF du système de gestion de batterie, et diagnostiquer si une batterie à gérer est anormale sur la base des informations d'état collectées.

6. Le système de gestion de batterie selon la revendication 5, dans lequel, lorsqu'une anomalie se produit dans une ou plusieurs batteries, le BMS esclave (200) transmet un signal d'anomalie au dispositif d'interface de communication (120) par l'intermédiaire du réseau de communication en série (300), et le dispositif d'interface de communication est configuré pour transmettre un signal de réveil au contrôleur (110) pour commuter le système de gestion de batterie à un état ON.

7. Le système de gestion de batterie selon la revendication 1, dans lequel les informations d'état sur le groupe de batteries incluent une ou plusieurs informations parmi une valeur de tension, une valeur de courant et une valeur de résistance d'isolement en unités de groupes de batteries, et dans lequel les informations d'état sur la ou les plusieurs batteries incluent une ou plusieurs informations parmi des valeurs de tension, des valeurs de courant et des valeurs de température en unités de cellules de batterie ou de sous-groupes de batteries.

8. Le système de gestion de batterie selon la revendication 1, dans lequel le dispositif de collecte d'informations d'état de groupe (130) est configuré comme un module intégré incluant un module de collecte d'informations de tension de groupe, un module de collecte d'informations de courant de groupe et un module de collecte d'informations de résistance d'isolement.

9. Procédé de fonctionnement d'un système de gestion de batterie (BMS) incluant une pluralité de BMS esclaves (200) et un BMS maître (100) connectés séquentiellement à la pluralité de BMS esclaves (200) par l'intermédiaire d'un réseau de communication en série (300), le procédé comprenant :
la collecte (S410), par la pluralité de BMS esclaves (200), d'informations d'état sur une ou plusieurs batteries ;
la collecte (S410), par un dispositif de collecte d'informations d'état de groupe (130) prévu dans le BMS maître (100), d'informations d'état sur le groupe de batteries incluant une pluralité de batteries ;
la réception (S420), par un contrôleur (110) du BMS maître (100), d'informations d'état sur la ou les plusieurs batteries et d'informations d'état sur le groupe de batteries par l'intermédiaire d'un dispositif d'interface de communication (120) du BMS maître (100) ; et
la surveillance (S430) d'une anomalie dans la ou les plusieurs batteries ou dans le groupe de batteries sur la base des informations d'état collectées,
**caractérisé en ce que** le contrôleur (110) et le dispositif d'interface de communication (120) sont connectés séquentiellement à la pluralité de BMS esclaves (200) et au dispositif de collecte d'informations d'état de groupe (130) par l'intermédiaire du réseau de communication en série, et
dans lequel la réception d'informations d'état inclut la réception des informations d'état sur la ou les plusieurs batteries et des informations d'état sur le groupe de batteries, dans lequel les informations d'état sur la ou les plusieurs batteries et les informations d'état sur le groupe de batteries sont générées en même temps.

10. Le procédé selon la revendication 9, dans lequel la surveillance (S430) d'une anomalie inclut le diagnostic du fait que la batterie ou le groupe de batteries est anormal sur la base des informations d'état reçues sur la ou les plusieurs batteries et des informations d'état sur le groupe de batteries.

11. Le procédé selon la revendication 9, dans lequel le dispositif d'interface de communication (120) est directement connecté à un BMS esclave (200) situé à l'extrémité de la pluralité de BMS esclaves (200) par l'intermédiaire du réseau de communication en série (300).
